Europäisches Patentamt

European Patent Office

Office européen des brevets

(19)

(11) **EP 1 693 418 A1**

(12) **EUROPEAN PATENT APPLICATION**
published in accordance with Art. 158(3) EPC

(43) Date of publication:
**23.08.2006 Bulletin 2006/34**

(51) Int Cl.:
***C08L 77/06*** (2006.01)

(21) Application number: **04820200.6**

(22) Date of filing: **07.12.2004**

(86) International application number:
**PCT/JP2004/018203**

(87) International publication number:
**WO 2005/056681 (23.06.2005 Gazette 2005/25)**

(84) Designated Contracting States:
**DE FR GB**

(30) Priority: **09.12.2003 JP 2003409801**

(71) Applicant: **Mitsui Chemicals, Inc.**
**Tokyo 105-7117 (JP)**

(72) Inventor: **OGASAWARA, Hideto**
**Sodegaura-shi,**
**Chiba 2990265 (JP)**

(74) Representative: **Simons, Amanda Louise**
**J.A. Kemp & Co.,**
**14 South Square,**
**Gray's Inn**
**London WC1R 5JJ (GB)**

(54) **RESIN COMPOSITION FOR LIGHT REFLECTOR AND LIGHT REFLECTOR**

(57)     [PROBLEMS] To provide a polyamide resin composition that is excellent in mechanical strength, heat resistance and adhesive properties to a sealing resin such as an epoxy resin of a molded product and that has no problem when used as precision insert molded products, and provide a reflector plate that realizes a reduced drop of light reflectance when the resin composition is used as the reflector plate.

[MEANS FOR SOLVING PROBLEMS] There is provided a polyamide resin composition comprising a specific polyamide resin composition comprising a polyamide resin (A), an inorganic filler (B), and a white pigment (C) whose molded product is excellent in mechanical strength and heat resistance; and also provided a polyamide resin composition further comprising a specific ultraviolet absorber (D), or both an ultraviolet absorber (D) and a hindered amine compound (E) and a reflector plate formed from the resin composition, which realize a reduced drop of light reflectance when the polyamide resin composition is used as the reflector plate.

EP 1 693 418 A1

**Description**

TECHNICAL FIELD

The present invention relates to a resin composition suitable for a reflector plate and a reflector plate formed from the resin composition. More particularly, the invention relates to a polyamide resin composition suitable for a reflector plate, which comprises a polyamide resin, an inorganic filler and a white pigment, which is excellent in reflectance, heat resistance, mechanical properties and adhesive properties to a sealing resin and which at the same time is suitable for insert molding, and which further realizes a reduced drop of light reflectance over the course of time when used as the reflector plate indoors and outdoors, and to a reflector plate formed from the resin composition.

BACKGROUND ART

Reflector plates for effectively using light have been used in various aspects. However, in recent years, due to the light source gaining semiconductance (semiconductor laser and light emitting diode (hereinafter referred to as LED)), the miniaturization of a light source and the miniaturization of a device are achieved, and thus it is required that the reflector plates to have not only high mechanical strength, but also good heat resistance and capability to be precisely molded. Particularly, in obtaining a reflector plate having high reflectance, a special insert molding has also been performed, and thus it has required a resin composition which can be used in this application.

In this field, conventional LCPs (liquid crystal polymers) and heat resistant polyamide resins have been used. The LCPs are superior in heat resistance and light resistance, and flowability during molding, but are inferior in adhesive properties to a sealing resin such as an epoxy resin used at sealing therewith after mounting a light emitting diode on a reflector plate.

Patent Documents 1 and 2 propose a resin composition for a reflector plate, which is made by blending an inorganic filler to a polyamide resin composed of 1,9-diaminononane. However, this resin composition has a problem in adhesive properties to a sealing resin. Further, Patent Document 4 describes a polyamide resin composition comprising an inorganic filler having an average particle size of 2 $\mu$m or less, and Patent Document 5 describes a polyamide resin containing potassium titanate fiber and/or wollastonite. However, these polyamide resins are not capable of obtaining sufficient rigidity during molding and have problems as being used in insert molding. Furthermore, Patent Documents 3, 6 and 7 describe a polyamide resin containing a specific light stabilizer and having a less discoloration of a molded product. However, these resins have problems in productivities due to occurrence of a mold deposit during molding.

[Patent Document 1] WO 03/085029

[Patent Document 2] JP-A No. 7-228776

[Patent Document 3] JP-A No. 2004-75994

[Patent Document 4] JP-A No. 2000-204244

[Patent Document 5] JP-A No. 2002-294070

[Patent Document 6] JP-A No. 2001-115014

[Patent Document 7] JP-A No. 2001-115015

DISCLOSURE OF THE INVENTION

[Problems to be solved by the Invention]

It is an object of the present invention to provide a polyamide resin composition that is excellent in mechanical strength and heat resistance of a molded product and has no problem as being used in precision insert molded products. It is another object of the invention to provide a reflector plate formed from the resin composition, which realizes a reduced drop of light reflectance over the course of time when used as the reflector plate.

[Means for solving the Problems]

In the light of these consideration, the present inventors have studied intensively, and as a result, they have found that a molded product formed of a specific polyamide resin composition comprising a polyamide resin (A), an inorganic filler (B) and a white pigment (C) is excellent in mechanical strength and heat resistance and no problems occur when the polyamide resin composition is use in precision insert molded product, and a polyamide resin composition further comprising a specific ultraviolet absorber (D), or both an ultraviolet absorber (D) and a hindered amine compound (E) and a reflector plate formed from the resin composition realizes a reduced drop of light reflectance over the course of time when used as the reflector plate indoors and outdoors, and thus have completed the present invention.

That is, the present invention provides:

(1) A polyamide resin composition which comprises 30 to 80% by mass of a polyamide resin (A) comprising (i) a dicarboxylic acid component unit (a-1) consisting of 30 to 100 mol% of a dicarboxylic acid component unit derived from terephthalic acid, 0 to 70 mol% of an aromatic dicarboxylic acid component unit other than the terephthalic acid, and/or 0 to 70 mol% of an aliphatic dicarboxylic acid component unit having 4 to 20 carbon atoms (provided that the total amount of these dicarboxylic acid component units is 100 mol%) and (ii) 100 mol% of a diamine component unit (a-2) consisting of a straight chain aliphatic diamine component unit having 4 to 20 carbon atoms and/or a branched chain aliphatic diamine component unit having 4 to 20 carbon atoms, as a diamine component unit, 10 to 60% by mass of an inorganic filler (B) and 5 to 50% by mass of a white pigment (C), in which a molded product that is injection molded from the polyamide resin composition has a flexural modulus of elasticity at 130°C of 4500 MPa to 12000 MPa;

(2) A polyamide resin composition which comprises 30 to 80% by mass of a polyamide resin (A) comprising (i) a dicarboxylic acid component unit (a-1) consisting of 30 to 100 mol% of a dicarboxylic acid component unit derived from terephthalic acid, 0 to 70 mol% of an aromatic dicarboxylic acid component unit other than the terephthalic acid, and/or 0 to 70 mol% of an aliphatic dicarboxylic acid component unit having 4 to 20 carbon atoms (provided that the total amount of these dicarboxylic acid component units is 100 mol%) and (ii) 100 mol% of a diamine component unit (a-2) consisting of a straight chain aliphatic diamine component unit having 4 to 20 carbon atoms and/or a branched chain aliphatic diamine component unit having 4 to 20 carbon atoms, as a diamine component unit, 10 to 60% by mass of an inorganic filler (B) and 5 to 50% by mass of a white pigment (C), in which the polyamide resin composition further comprises an ultraviolet absorber (D) having a heating mass reduction ratio of 50% by mass or less when held at 340°C for 10 minutes under a nitrogen atmosphere, or both an ultraviolet absorber (D) and a hindered amine compound (E); and

(3) A reflector plate and a reflector plate for a light emitting diode device, which are formed from the polyamide resin composition.

[Effects of the Invention]

The invention can provide a polyamide resin composition which has high light reflectance, high light stability and good adhesive properties to a sealing resin, and which can obtain a reflective plate molded product comprising an insert molded-hoop material and a resin, which does not occur problems in a post-process such as a set process of LED by a sealing resin such as an epoxy resin and a solder reflow process, and a reflector plate formed from the resin composition.

BEST MODE FOR CARRYING OUT THE INVENTION

Hereinafter, the present invention will be explained in detail.

[Polyamide resin (A)]

The polyamide resin (A) used in the invention comprises a dicarboxylic acid component unit (a-1) and a diamine component unit (a-2).

[Dicarboxylic acid component unit (a-1)]

The dicarboxylic acid component unit (a-1) constituting the polyamide resin (A) used in the invention preferably comprises 30 to 100 mol% of a terephthalic acid component unit, 0 to 70 mol% of an aromatic dicarboxylic acid component unit other than the terephthalic acid, and/or 0 to 70 mol% of an aliphatic dicarboxylic acid component unit having 4 to 20 carbon atoms. Among these, as the aromatic dicarboxylic acid component unit other than the terephthalic acid, for example, isophthalic acid, 2-methylterephthalic acid, naphthalene dicarboxylic acid and a combination thereof are preferred.

Further, the aliphatic dicarboxylic acid component unit, even though the number of carbon atoms thereof is not particularly limited, is derived from an aliphatic dicarboxylic acid having 4 to 20 carbon atoms and preferably 6 to 12 carbon atoms. Examples of the aliphatic dicarboxylic acid used for deriving the aliphatic dicarboxylic acid component unit include adipic acid, suberic acid, azelaic acid, sebacic acid, decanedicarboxylic acid, undecanedicarboxylic acid, dodecanedicarboxylic acid and the like. Among these, the adipic acid is particularly preferred.

Further in the invention, when the amount of the dicarboxylic acid component unit in the polyamide resin is 100 mol%, the polyamide resin preferably contains the terephthalic acid component unit in an amount of 30 to 100 mol%, preferably 40 to 100 mol%, and more preferably 40 to 80 mol%; the aromatic dicarboxylic acid component unit other than the terephthalic acid in an amount of 0 to 70 mol%, preferably 0 to 60 mol%, and more preferably 20 to 60 mol%;

and/or the aliphatic dicarboxylic acid having 4 to 20 carbon atoms, preferably 6 to 12 carbon atoms in an amount of 0 to 70 mol%, preferably 0 to 60 mol% and more preferably 20 to 60 mol%.

Furthermore in the invention, the polyamide resin may contain, as a dicarboxylic acid component unit (a-1), a polyvalent carboxylic acid component unit in a small amount, for example, in an amount of about 10 mol% or less, together with the above-mentioned component units. Specific examples of the polyvalent carboxylic acid component unit include tribasic or polybasic acid such as trimellitic acid or pyromellitic acid.

[Diamine component unit (a-2)]

The diamine component unit (a-2) constituting the polyamide resin (A) used in the invention is preferably a straight chain and/or branched chain aliphatic diamine having 4 to 20 carbon atoms, preferably 6 to 12 carbon atoms.

Specific examples of the straight chain aliphatic diamine component unit include 1,4-diaminobutane, 1,6-diaminohexane, 1,7-diaminoheptane, 1,8-diaminooctane, 1,9-diaminononane, 1,10-diaminodecane, 1,11-diaminoundecane and 1,12-diaminododecane. Of these, it is preferable to contain 1,6-diaminohexane in an amount of 50 to 100 mol%.

Specific examples of the branched straight chain aliphatic diamine component unit include 2-methyl-1,5-diaminopetane, 2-methyl-1,6-diaminohexane, 2-methyl-1,7-diaminoheptane, 2-methyl-1,8-diaminooctane, 2-methyl-1,9-diaminononane, 2-methyl-1,10-diaminodecane, 2-methyl-1,11-diaminoundecane and the like. Of these, 2-methyl-1,7-diaminoheptane, 2-methyl-1,8-diaminooctane and 2-methyl-1,9-diaminononane are preferred.

The polyamide resin (A) used in the invention can be prepared by a known method and prepared by the polycondensation of a dicarboxylic acid component with a diamine component. For example, as described in WO 03/085029, the polyamide resin can be prepared by heating the dicarboxylic acid component and the diamine component in the presence of a catalyst to obtain a lower condensate and subsequently by carrying out the polycondensation by the application of shear stress to a melt of the lower condensate.

The polyamide resin (A) used in the invention has an intrinsic viscosity $[\eta]$, as measured in 96.5% sulfuric acid at 25°C, of 0.5 to 0.9 [dl/g], preferably 0.6 to 0.9 [dl/g], and more preferably 0.7 to 0.9 [dl/g]. When it is in the above ranges, the polyamide resin has excellent flowability during molding. Further, the polyamide resin has a melting point, as measured by DSC, usually in the range of 260 to 350°C, and particularly preferably in the range of 290 to 335°C. The polyamide resin having the above melting point ranges is particularly excellent in heat resistance.

[Inorganic filler (B)]

As the inorganic filler (B) used in the invention, there can be various inorganic reinforcing materials in the form of fiber, powder, granule, plate, needle, cloth, mat, and the like used. More specifically, the inorganic filler include inorganic fibers such as glass fiber, metal-coated glass fiber, ceramic fiber, carbon fiber, metal carbide fiber, hardened metal fiber, asbestos fiber and boron fiber. Of these fibrous fillers, the glass fiber is particularly preferable. By using the glass fiber, the moldability of the composition improves and further improves mechanical properties such as tensile strength, bending strength and flexural modulus of elasticity, and heat resisting property such as thermal deformation temperature of the molded product formed from the resin composition. The glass fiber has an average length of usually in the range of 0.1 to 20 mm, preferably in the range of 0.3 to 6 mm and an aspect ratio (L (average length of fiber) / D (average outer diameter of fiber) of usually in the range of 10 to 2000, preferably in the range of 30 to 600. It is preferable to use the glass fiber having the average length and the aspect ratio in the above-mentioned ranges.

[White pigment (C)]

Examples of the white pigment (C) used in the invention include titanium oxide, zinc oxide, zinc sulfide, white lead, zinc sulfate, barium sulfate, calcium carbonate, alumina oxide and the like.

These white pigments may be used alone or in combination of two or more kinds. Moreover, these white pigments can also be used after treating them with a silane coupling agent, a titanium coupling agent or the like. For example, the white pigments may be surface-treated with a silane compound such as vinyltriethoxysilane, 2-aminopropyltriethoxysilane and 2-glycidoxypropyltriethoxysilane. As the white pigments, titanium oxide is particularly preferable, and by using titanium oxide, the optical properties such as reflectance and concealability improve. Further, a rutile-type titanium oxide is preferably used as titanium oxide. Furthermore, a particle size of titanium oxide is 0.05 to 2.0 $\mu$m, preferably 0.05 to 0.7 $\mu$m.

[Ultraviolet absorber (D)]

The polyamide resin composition of this invention can prevent the discoloration and realize the reduced drop of reflectance in a reflector plate obtained by molding the polyamide resin composition by adding a specific ultraviolet absorber (D), or both an ultraviolet absorber (D) and a hindered amine compound (E).

The ultraviolet absorber (D) of the invention preferably has a heating mass reduction ratio of 0 to 50% by mass, preferably 0 to 40% by mass, and more preferably 0 to 30% by mass when held at 340°C for 10 minutes after elevating the temperature at 20°C/min from 25°C to 340°C under a nitrogen atmosphere.

Further, the ultraviolet absorber (D) particularly preferably comprises one or more compounds selected from a benzotriazole compound, a triazine compound or a benzophenone compound.

Specific examples of the ultraviolet absorber include 2-[2'-hydroxy-3'-(3",4",5",6"-tetrahydrophthalimidemethl)-5'-methylphenyl]-benzotriazole, 2-(4,6-diphenyl-1,3,5-triazin-2-yl)-5-[(hexyl)oxy]-phenol, 2-[4,6-bis(2,4-dimethylphenyl)-1,3,5-triazin-2-yl]-5-(octyloxy)phenol and the like.

[Hindered amine compound (E)]

In the invention, a higher light stability can be obtained by using a combination of the above-mentioned ultraviolet absorber (D) and a hindered amine compound (E).

The hindered amine compound (E) of the invention preferably has a heating mass reduction ratio of 0 to 50% by mass, preferably 0 to 40% by mass, and more preferably 0 to 30% by mass when held at 340°C for 10 minutes after elevating the temperature at 20°C/min from 25°C to 340°C under a nitrogen atmosphere.

Specific examples of the hindered amine compound (E) include N,N',N'',N'''-tetrakis-(4,6-bis-(butyl-(N-methyl-2,2,6,6-tetramethylpiperidin-4-yl)amino)-triazin-2-yl)-4,7-diazadecane-1,10-diamine, poly[{6-((1,1,3,3= tetramethylbutyl)amino)-1,3,5-triazine-2,4-diyl}{(2,2,6,6-tetramethyl-4-piperidyl)imino}hexamethylene{(2,2,6,6-tetramethyl-4-piperidyl)imino}] and the like.

[Additives]

The polyamide resin composition of the invention may be incorporated with the following additives, specifically, various known compounding agents such as an antioxidant (phenols, amines, sulfur, phosphorous, etc.), a heat stabilizer (lactone compound, vitamin E group, hydroquinones, copper halide, iodine compound, etc.), a light stabilizer (benzotriazoles, triazines, benzophenones, benzoates, hindered amines, oxanilides, etc.), other polymers (olefins, modified polyolefines, an olefin copolymer such as an ethylene/propylene copolymer and an ethylene/1-butene copolymer, an olefin copolymer such as a propylene/1-butene copolymer, polystyrene, polyamide, polycarbonate, polyacetal, polysulfone, polyphenylene oxide, a fluororesin, a silicone resin, LCP, etc.), a flame retardant (bromine-based, chlorine-based, phosphorus-based, antimony-based, inorganic-based, etc.), a fluorescent brightener, a plasticizer, a thickener, an antistatic agent, a release agent, a pigment and a nucleating agent, in accordance with its application within limits not harmful to the effects of the present invention.

[Polyamide resin composition of the invention]

The polyamide resin composition of the invention can be produced by a known method, for example, by mixing the above-described components using a Henschel mixer, a V blender, a ribbon blender, a tumbler blender or the like, or granulating or crushing the mixed components after they are melt-kneaded using a single-screw or multi-screw extruder, a kneader, a Banbury mixer or the like.

Further, the polyamide resin composition of the invention preferably contains the polyamide resin (A) in an amount of 30 to 80% by mass, preferably 40 to 70% by mass, more preferably 45 to 65% by mass, based on 100% by mass of the total amount of the polyamide resin (A), the inorganic filler (B) and the white pigment (C).

The inorganic filler (B) is preferably added to the polyamide resin composition in a proportion of 10 to 60% by mass, preferably 15 to 50% by mass, more preferably 20 to 40% by mass, based on 100% by mass of the total amount of the polyamide resin (A), the inorganic filler (B) and the white pigment (C).

The white pigment (C) is preferably added to the polyamide resin composition in a proportion of 5 to 50% by mass, preferably 5 to 40% by mass, more preferably 5 to 35% by mass, based on 100% by mass of the total amount of the polyamide resin (A), the inorganic filler (B) and the white pigment (C).

The ultraviolet absorber (D) is preferably added to the polyamide resin composition in a proportion of 0.05 to 3 parts by mass, preferably 0.05 to 2 parts by mass, based on 100 parts by mass of the polyamide resin (A).

The hindered amine compound (E) is preferably added to the polyamide resin composition in a proportion of 0.05 to 3 parts by mass, preferably 0.05 to 2 parts by mass, based on 100 parts by mass of the polyamide resin (A).

The polyamide resin composition of the invention obtained by the above-mentioned method can be suitably used as a reflector plate in that it is excellent in light reflectance, heat resistance, and adhesive properties to a sealing resin such as an epoxy resin and it further realizes a reduced drop of reflectance when used as the reflector plate indoors and outdoors. Further, a molded product that is injection molded from the polyamide resin composition, with a length of 64 mm, a width of 6 mm and a thickness of 0.8 mm, has a flexural modulus of elasticity of 45.00 MPa to 12000 MPa, preferably 4500 MPa to 10000 MPa, as obtained by measuring in an atmosphere at 130°C under the conditions of a span of 26 mm and a bending speed of 5 mm/min after being placed in an air oven at 130°C for 20 minutes, and sufficient rigidity is obtained at the time of insert molding thereof, and therefore there does not occur a problem such as peeling in use in insert molded products.

[Reflector plate and reflector plate for light emitting diode device]

The term "reflector plate" as used herein includes a Chinese character called a "plate", but the concept of this term is not limited to only one having a "plate" shape.
This term includes normal casings or housings in which at least the direction side to which light is emitted is opened or not opened. More specifically, the term "reflector plate" further includes those having general three-dimensional shapes, provided with a plate (surfaces such as a flat surface, a spherical surface and a curved surface) as the surface to which light is reflected, such as a box or case, a funnel, a bowl, a parabola, a cylinder, a cone and a honeycomb.

In the invention, a reflector plate for an LED device is shaped into a desired shape by hot forming such as injection molding (metal insert molding such as hoop molding), melt molding, extrusion molding, inflation molding, and blow molding of a resin composition usually comprising a polyamide resin or both a polyamide resin and an inorganic filler. The LED reflector plate of the invention is usually sealed, bonded and adhered to an LED device and other components with a sealing resin.

Further, the polyamide resin composition and the reflector plate of the invention can be adapted not only for an LED application, but also for other applications reflecting light beams. Specifically, it is possible to use as a reflector plate for a light emitting device such as various electric/electronic products, indoor lighting, ceiling area lighting, outdoor lighting, automobile lighting, a display apparatus, and a headlight.

The reflector plate can be prepared by heat melting the polyamide resin composition for a reflector plate of the invention to shape into a desired shape and then cooling the resultant. This shaping can be obtained by a method of melt molding the polyamide resin composition in a mold capable of forming a desired shape. Specifically, the polyamide resin composition can be molded into a reflector plate using a known method such as injection molding, compression molding and extrusion molding.

Moreover, the reflecting plate or the reflecting plate for a light emitting diode device formed from the polyamide resin composition of the invention preferably has reflectance retention of 80 to 100%, preferably 80 to 90%, more preferably 82 to 85%, as calculated by measuring light reflectance at a wavelength of 470 nm before and after light is irradiated with a metal halide lamp at 40 mW/cm$^2$ for 48 hours.

[Examples]

Hereafter, the present invention is specifically explained on the basis of Examples, but the invention is not limited to these Examples. In Examples and Comparative Examples, the measurement and evaluation of the respective properties were carried out according to the methods described below.

[Intrinsic viscosity [η]]

0.5 g of a polyamide resin was dissolved in 50 ml of a 96.5% sulfuric acid solution, and the number of seconds required for a sample solution to drop under the conditions of 25°C ± 0.05°C was measured using an Ubellohde viscometer and was calculated based on the following formulas:

$$[\eta] = \eta SP/[C(1+0.205\eta SP), \quad \eta SP = (t-t0)/t0$$

[η]: intrinsic viscosity (dl/g), ηSP: specific viscosity, C: concentration of sample (g/dl), t: number of seconds required for sample solution to drop (seconds), and t0: number of seconds required for sulfuric acid as a blank to drop (seconds)

[Melting point]

A DSC-7 available from PerkinElmer, Inc. was used. A sample was once held at 330°C for 5 minutes and followed by cooling to 23°C at a rate of 10°C/min. Then, the temperature of the sample was elevated at 10°C/min and an endothermic peak based on melting at this time was defined as a melting point.

[Flexural modulus of elasticity]

An injection molded specimen having a length of 64 mm, a width of 6 mm and a thickness of 0.8 mm was subjected to a bending test in an atmosphere at 130°C under the conditions of a span of 26 mm and a bending speed of 5 mm/min, to measure the flexural modulus of elasticity.
Molding machine: TUPARL TR40S3A manufactured by Sodick Plustech Co., Ltd.
Temperature of cylinder: 335°C
Temperature of mold: 120°C
Bending tester: INTESCO-Model 205 manufactured by INTESCO CO., LTD.

[Reflectance]

Reflectances at wavelengths of 470 nm, 520 nm and 650 nm were measured using an injection molded specimen having a thickness of 2 mm. The results of the evaluation were indicated by the symbols O: reflectance of 85% or more and x: reflectance of less than 85%.
Molding machine: IS-55EPN manufactured by TOSHIBA MACHINE CO., LTD. (Temperature of cylinder: 335°C, Temperature of mold: 120°C)
Measuring apparatus of reflectance: CM3500d manufactured by Minolta Co., Ltd.

[Evaluation of peeling properties]

A cup-shaped molded product having a length of 3 mm, a width of 2.5 mm and a height of 2 mm was obtained by hoop molding and an aqueous ink was dropped onto the contact portion of a hoop material and the cup-shaped molded product to examine whether or not the aqueous ink permeates into the contact surface of the cup-shaped molded product and the hoop material by the capillary phenomenon. The results of the evaluation were indicated by the symbols O: no permeation and x: permeation.

[Heating mass reduction ratio]

The heating mass reduction ratio of the ultraviolet absorber (D) and the hindered amine compound (E) were measured by thermogravimetric analysis (TG) to examine a TG curve when held at 340°C for 10 minutes after elevating the temperature at a rate of 20°C/min from 25°C to 340°C under a nitrogen atmosphere, and to calculate a mass reduction ratio before and after heating with regard to the ultraviolet absorber (D) and the hindered amine compound (E), based on the following formula:

$$\text{Heating mass reduction ratio (\%)} = (W1-W2)/W1 \times 100$$

W1: Mass before heating
W2: Mass after heating

[Reflectance retention]

A specimen having a thickness of 2 mm was fabricated by an injection molding machine and the ratio of reflectance after light irradiation to reflectance before light irradiation was calculated by measuring light reflectance at a wavelength of 470 nm before and after light irradiation of the specimen with a metal halide lamp at 40 mW/cm$^2$ for 48 hours, based on the following formula:

$$\text{Reflectance retention (\%)} = (R1-R2)/R1 \times 100$$

R1: Light reflectance at wavelength of 470 nm before light irradiation with metal halide lamp
R2: Light reflectance at wavelength of 470 nm after light irradiation with metal halide lamp

Molding machine: IS-55EPN manufactured by TOSHIBA MACHINE CO., LTD. (Temperature of cylinder: 335°C, Temperature of mold: 120°C)

Light irradiation apparatus: Eye super UV tester manufactured by DAINIPPON PLASTICS CO., LTD. (40 mW/cm$^2$, 48 h)

Measuring apparatus of reflectance: CM3500d manufactured by Minolta Co., Ltd.

[Examples 1 and 2 and Comparative Example 1]

The polyamide resin (A1), the inorganic filler (B) and the white pigment (C) were mixed together at ratios shown in Table 1 using a tumbler blender, and were fed into a twinscrew extruder equipped with a vent (BT-40 manufactured by PLASTIC ENGINEERING RESEARCH CO., LTD.) and melt-kneaded therein at a setpoint temperature of 320°C to prepare pellet-shaped resin compositions. Then, the respective properties of the obtained resin compositions were evaluated and the results thereof are shown in Table 1.

Polyamide resin (A)

Composition: dicarboxylic acid component unit (terephthalic acid/62.5 mol% and adipic acid/37.5 mol%) and diamine component unit (1,6-diaminohexane/100 mol%)
Intrinsic viscosity [η]: 0.8 dl/g
Melting point: 320°C
Inorganic filler (B): glass fiber (length of 3 mm and aspect ratio of 300)
White pigment (C): titanium oxide (powder, average particle size of 0.21 μm)

[Comparative Examples 2 and 3]

Pellet-shaped resin compositions were prepared in the same manner as in Example 1, except that the polyamide resin (A1) was changed to the polyamide resin (A2). Then, the respective properties of the obtained resin compositions were evaluated and the results thereof are shown in Table 1.

Polyamide resin (A2)

Composition: dicarboxylic acid component unit (terephthalic acid/62.5 mol% and adipic acid/37.5 mol%) and diamine component (1,6-diaminohexane/100 mol%)
Intrinsic viscosity [η]: 1.0 dl/g
Melting point: 320°C

[Examples 3 to 6 and Comparative Examples 4 and 5]

Pellet-shaped resin compositions were prepared in the same manner as in Example 2, except that ultraviolet absorbers (D1) and (D2) and hindered amine compounds (D3) and (D4) were added at ratios shown in Table 1, based on 100 parts by mass of the polyamide resin (A1).

Then, the respective properties of the obtained resin compositions for a reflector plate were evaluated and the results thereof are shown in Table 1.
Ultraviolet absorber (D1): 2-(4,6-diphenyl-1,3,5-triazin-2-yl)-5-[(hexyl)oxy]-phenol
Trade name: TINUVIN 1577FF manufactured by Ciba Speciality Chemicals, Inc. (heating mass reduction ratio of 20%)
Ultraviolet absorber (D2): ethanediamide, N-(2-ethoxyphenyl)-N'-(2-ethylphenyl)-ethanediamine
Trade name: TINUVIN 312 manufactured by Ciba Speciality Chemicals, Inc. (heating mass reduction ratio of 100%)
Hindered amine compound (D3): a mixture of N,N',N'',N'''-tetrakis-(4,6-bis-(butyl-(N-methyl-2,2,6,6-tetramethylpiperidin-4-yl)amino)-triazin-2-yl)-4,7-diazadecane-1,10-diamine (A) and polymer (B) of dimethyl succinate and 4-hydroxy-2,2,6,6-tetramethyl-1-piperidine ethanol
Trade name: CHIMASSORB119FL manufactured by Ciba Speciality Chemicals, Inc. (heating mass reduction ratio of 10%)
Hindered amine compound (D4): poly[{6-((1,1,3,3-tetramethylbutyl)amino)-1,3,5-triazine-2,4-diyl}{(2,2,6,6-tetramethyl-4-piperidyl)imino}hexamethylene{(2,2,6,6-tetramethyl-4-piperidyl)imino}]
Trade name: CHIMASSORB944FDL manufactured by Ciba Speciality Chemicals, Inc. (heating mass reduction ratio of 4%)

[Table 1]

| | Unit | Ex. 1 | Ex. 2 | Ex. 3 | Ex. 4 | Ex. 5 | Ex. 6 | Comp. Ex. 1 | Comp. Ex. 2 | Comp. Ex. 3 | Comp. Ex. 4 | Comp. Ex. 5 |
|---|---|---|---|---|---|---|---|---|---|---|---|---|
| Polyamide resin (A1) | % by mass | 60 | 60 | 60 | 60 | 60 | 60 | 67 | 0 | 0 | 60 | 60 |
| Polyamide resin (A2) | % by mass | 0 | 0 | 0 | 0 | 0 | 0 | 0 | 67 | 60 | 0 | 0 |
| Intrinsic viscosity [η] | dl/g | 0.8 | 0.8 | 0.8 | 0.8 | 0.8 | 0.8 | 0.8 | 1 | 1 | 0.8 | 0.8 |
| Inorganic filler (B) | % by mass | 30 | 25 | 25 | 25 | 25 | 25 | 22 | 22 | 30 | 25 | 25 |
| White pigment (C) | part(s) by mass | 11 | 15 | 15 | 15 | 15 | 15 | 11 | 11 | 11 | 15 | 15 |
| Ultraviolet absorber (D1) | part(s) by mass | 0 | 0 | 0.3 | 0.4 | 0.3 | 0.4 | 0 | 0 | 0 | 0 | 0 |
| Ultraviolet absorber (D2) | part(s) by mass | 0 | 0 | 0 | 0 | 0 | 0 | 0 | 0 | 0 | 0.3 | 0 |
| Hindered amine compound (D3) | part(s) by mass | 0 | 0 | 0.6 | 0.8 | 0 | 0 | 0 | 0 | 0 | 0.6 | 0.8 |
| Hindered amine compound (D4) | part(s) by mass | 0 | 0 | 0 | 0 | 0.6 | 0 | 0 | 0 | 0 | 0 | 0 |
| flexural modulus of elasticity | MPa | 6000 | 5000 | 5000 | 5000 | 5000 | 5000 | 4000 | 4000 | 6000 | 5000 | 5000 |
| Peeling properties | - | O | O | O | O | O | O | × | × | Poor filling | O | O |
| Reflectance | 470 nm | O | O | O | O | O | O | O | O | O | O | O |
| | 520 nm | O | O | O | O | O | O | O | O | O | O | O |
| | 650 nm | O | O | O | O | O | O | O | O | O | O | O |

EP 1 693 418 A1

[Table 1. Continued]

| Reflectance retention | % | Not determined | 78 | 82 | 83 | 84 | 80 | Not determined | Not determined | Not determined | 78 | 78 |
|---|---|---|---|---|---|---|---|---|---|---|---|---|

INDUSTRIAL APPLICABILITY

The polyamide resin composition according to the present invention having excellent mechanical strength and

10

excellent heat resistance, high light reflectance, high light shielding properties and high light resistance can be suitably used as a reflector plate for an LED device or a reflector plate for a light emitting device such as various electric/electronic products, indoor lighting, ceiling area lighting, outdoor lighting, automobile lighting, a display apparatus, and a headlight.

**Claims**

1. A polyamide resin composition which comprises 30 to 80% by mass of a polyamide resin (A) comprising (i) a dicarboxylicacid component unit (a-1) consisting of 30 to 100 mol% of a dicarboxylic acid component unit derived from terephthalic acid, 0 to 70 mol% of an aromatic dicarboxylic acid component unit other than the terephthalic acid, and/or 0 to 70 mol% of an aliphatic dicarboxylic acid component unit having 4 to 20 carbon atoms (provided that the total amount of these dicarboxylic acid component units is 100 mol%) and (ii) 100 mol% of a diamine component unit (a-2) consisting of a straight chain aliphatic diamine component unit having 4 to 20 carbon atoms and/or a branched chain aliphatic diamine component unit having 4 to 20 carbon atoms, as a diamine component unit; 10 to 60% by mass of an inorganic filler (B); and 5 to 50% by mass of a white pigment (C), wherein a molded product that is injection molded from the polyamide resin composition has a flexural modulus of elasticity at 130°C of 4500 MPa to 12000 MPa.

2. A polyamide resin composition which comprises 30 to 80% by mass of a polyamide resin (A) comprising (i) a dicarboxylic acid component unit (a-1) consisting of 30 to 100 mol% of a dicarboxylic acid component unit derived from terephthalic acid, 0 to 70 mol% of an aromatic dicarboxylic acid component unit other than the terephthalic acid, and/or 0 to 70 mol% of an aliphatic dicarboxylic acid component unit having 4 to 20 carbon atoms (provided that the total amount of these dicarboxylic acid component units is 100 mol%) and (ii) 100 mol% of a diamine component unit (a-2) consisting of a straight chain aliphatic diamine component unit having 4 to 20 carbon atoms and/or a branched chain aliphatic diamine component unit having 4 to 20 carbon atoms, as a diamine component unit; 10 to 60% by mass of an inorganic filler (B); and 5 to 50% by mass of a white pigment (C), wherein the polyamide resin composition further comprises an ultraviolet absorber (D) having a heating mass reduction ratio of 50% by mass or less when held at 340°C for 10 minutes under a nitrogen atmosphere, or both an ultraviolet absorber (D) and a hindered amine compound (E).

3. The polyamide resin composition according to claim 2, wherein the ultraviolet absorber (D) is one or more compounds selected from a benzotriazole compound, a triazine compound or a benzophenone compound.

4. The polyamide resin composition according to claims 1 to 3, wherein the polyamide resin (A) has an intrinsic viscosity [η] of 0.5 to 0.9 dl/g and a melting point of 260 to 350°C.

5. The polyamide resin composition according to claims 1 to 3, wherein the diamine component unit (a-2) of the polyamide resin (A) comprises one or more kinds selected from 1,6-diaminohexane, 1,10-diaminodecane, 1,11-diaminoundecane and 1,12-diaminododecane.

6. The polyamide resin composition according to claims 1 to 3, wherein the inorganic filler (B) is glass fiber.

7. The polyamide resin composition according to claims 1 to 3, wherein the white pigment (C) is titanium oxide.

8. A reflector plate which is formed from the polyamide resin composition according to claims 1 to 3.

9. A reflector plate for a light emitting diode device, which is formed from the polyamide resin composition according to claims 1 to 3.

10. The reflector plate for a light emitting diode according to claim 9, wherein reflectance retention is 80% or more.

## INTERNATIONAL SEARCH REPORT

| International application No. |
|---|
| PCT/JP2004/018203 |

A. CLASSIFICATION OF SUBJECT MATTER
Int.Cl⁷ C08L77/06, C08K3/00, C08K5/3467, C08K5/07, C08K5/17

According to International Patent Classification (IPC) or to both national classification and IPC

B. FIELDS SEARCHED

Minimum documentation searched (classification system followed by classification symbols)
Int.Cl⁷ C08L77/00-77/12, C08K3/00-13/08

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2004 |
| Kokai Jitsuyo Shinan Koho | 1971-2004 | Toroku Jitsuyo Shinan Koho | 1994-2004 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2002-294070 A (Otsuka Chemical Co., Ltd.),<br>09 October, 2002 (09.10.02),<br>Claims 1 to 3; Par. Nos. [0021] to [0024];<br>examples 1 to 8<br>(Family: none) | 1,4-10<br>2,3 |
| Y | JP 2000-300131 A (Kureha Chemical Industry Co., Ltd.),<br>31 October, 2000 (31.10.00),<br>Claims 1 to 5; Par. No. [0007]<br>(Family: none) | 2,3 |
| A | JP 7-228776 A (Kuraray Co., Ltd.),<br>29 August, 1995 (29.08.95),<br>Claims 1, 2; Par. No. [0023]<br>(Family: none) | 1-10 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>11 January, 2005 (11.01.05) | Date of mailing of the international search report<br>01 February, 2005 (01.02.05) |
|---|---|
| Name and mailing address of the ISA/<br>Japanese Patent Office | Authorized officer |
| Facsimile No. | Telephone No. |

Form PCT/ISA/210 (second sheet) (January 2004)

**INTERNATIONAL SEARCH REPORT**

International application No.

PCT/JP2004/018203

C (Continuation).   DOCUMENTS CONSIDERED TO BE RELEVANT

| Category* | Citation of document, with indication, where appropriate, of the relevant passages | Relevant to claim No. |
|---|---|---|
| A | JP 6-157902 A   (Asahi Chemical Industry Co., Ltd.), 07 June, 1994 (07.06.94), Claims 1, 2 (Family: none) | 1-10 |
| P,X | JP 2004-75994 A  (Kuraray Co., Ltd.), 11 March, 2004 (11.03.04), Claims 1 to 6; Par. Nos. [0025] to [0028], [0034]; examples 1 to 5 & EP 1375578 A1        & US 2004/034152 A | 1-10 |

Form PCT/ISA/210 (continuation of second sheet) (January 2004)